# EUROPEAN PATENT APPLICATION

(11) **EP 1 898 687 A1**
(43) Date of publication of application: **12.03.2008**
(21) Application number: 07115845.5
(22) Date of filing: 06.09.2007
(51) Int. Cl.: H05K 9/00

(54) **Electromagnetic-shielding Device**

(30) Priority: 06.09.2006 CN 200620136602 U; 12.04.2007 CN 200720141454 U
(71) Applicant: Horng, Chin-Fu, Taipei Hsien Lu Chou City (TW)
(72) Inventor: Horng, Chin-Fu, Lu Chou City, taipey Hsien (TW)
(74) Representative: Viering, Jentschura & Partner

(57) **Abstract**

An electromagnetic-shielding device is disclosed to shield EMI by way of covering an electromagnetic-shielding mask on electric components. Wherein a positioning structure is downward elongated from the electromagnetic-shielding mask into a hole of a PCB, and an interfering structure of the positioning structure then interferes a surface of a bottom of the PCB or a surface of the hole of the PCB in order to firmly mount the electromagnetic-shielding mask on the PCB.

## Description

### BACKGROUND OF THE INVENTION

### 1. Field of the Invention

The present invention generally relates to an electromagnetic-shielding device, more particular to an electromagnetic-shielding device, which electric components thereon are covered for shielding electromagnetic interference.

### 2. Description of the Prior Art

It is possible to avoid interference with the electric components such as CPUs, chips, etc. of the PCBs in a mobile phone, PDA i.e. personal digital assistant, laptop, etc. by outside EMI (electromagnetic interference), so that the components can work properly. On the other hand, the EMI leaking from some powered electric components should also be shielded so as to avoid electromagnetic interference of other outside electronic devices and organisms.

An electromagnetic-shielding mask in the prior art is mounted on a PCB and covers electric components. Such an electromagnetic mask is mounted on the PCB by the ways of welding, fastening, etc. in order to shield EMI.

However, if welding is adopted, the materials for welding and applying a weld are then limited. Further, the procedures are complicated and the cost of materials is relatively high. On the other hand, the electromagnetic-shielding mask is not easily dismantled during maintenance.

Therefore, the problem to be solved is how to provide an advanced structure for the electromagnetic-shielding mask which is simply and effectively installed.

### SUMMARY OF THE INVENTION

The primary objective of the present invention is to provide an electromagnetic-shielding device in an electronic device. The electromagnetic-shielding device is suitable for most materials and flexibly applied in order to save material cost.

The primary objective of the present invention is to provide the electromagnetic-shielding device, which is easily dismantled and assembled so as to highly decrease labour cost.

To achieve the above objectives, the present invention provides the electromagnetic-shielding device disposed in an electronic device for shielding electromagnetic interference, a PCB and an electric component thereon being disposed in the electronic device, and comprising: a shielding mask disposed on the PCB and covered the electric component; at least one positioning structure, which at one end is firmly connected to the shielding mask and elongated downward from the shielding mask, another end being elongated downward into at least one hole of the PCB; and at least one interfering structure disposed at the one end of the positioning structure and interfering the PCB in order to stably dispose the shielding mask on the PCB. An example of an interfering structure is a structure interposing or intervening itself into the structure of the PCB, or a structure which fastens to the PCB. By PCB is meant printed circuit board.

Wherein the ways of interference are that: the interfering structure of the positioning structure interferes in the surface of the bottom of the PCB and the interfering structure of the positioning structure interferes in the surface of the hole of the PCB.

The interfering structure can be a reverse hook structure, a protruding structure, a bending structure, etc. It is that the PCB is interfered in by the interfering structure so as to firmly fix the positioning structure on the PCB, and the electromagnetic-shielding mask then be mounted on the PCB.

The electromagnetic-shielding mask is a metal member for better electromagnetic-shielding effect.

Thus, the present invention adopts the positioning structure, the interfering structure, and the hole of the PCB to assemble each other so as to produce the electromagnetic-shielding device of the electronic device. The range of applied materials is wider, and the electromagnetic-shielding device is easily dismantled and assembled so as to save manufacturing and maintenance cost.

Other and further features, advantages, and benefits of the invention will become apparent in the following description taken in conjunction with the following drawings. It is to be understood that the foregoing general description and following detailed description are exemplary and explanatory but are not to be restrictive of the invention. The accompanying drawings are incorporated in and constitute a part of this application and, together with the description, serve to explain the principles of the invention in general terms. Like numerals refer to like parts throughout the disclosure.

### BRIEF DESCRIPTION OF THE DRAWINGS

The objects, spirits, and advantages of the preferred embodiments of the present invention will be readily understood by the accompanying drawings and detailed descriptions, wherein:
Fig. 1 illustrates a schematic side sectional view of an electromagnetic-shielding device combining with a PCB of the present invention;
Fig. 2 illustrates a schematic top view of the electromagnetic-shielding device combining with the PCB of the present invention;
Fig. 3 illustrates a schematic view of a positioning member traverse moving toward to an inner side of an electromagnetic-shielding mask of the present invention;
Fig. 4 illustrates a schematic view of a protruding structure of an interfering structure of the present invention;
Fig. 5 illustrates a schematic view of a bending structure of the interfering structure of the present invention;
Fig. 6 illustrates a schematic view of installing a positioning structure of the present invention;
Fig. 7 illustrates another schematic view of installing the positioning structure of the present invention;
Fig. 8 illustrates a schematic view of a first preferred embodiment of the interfering structure interfering in a surface of a hole of the present invention;
Fig. 8A illustrates an embodiment of the interfering structure;
Fig. 9 illustrates a schematic view of a second preferred embodiment of the interfering structure interfering in the surface of the hole of the present invention;
Fig. 9A illustrates an embodiment of the interfering structure; and
Fig. 10 illustrates a schematic view of a first preferred embodiment of the interfering structure interfering in the surface of the hole of the present invention.

### DETAILED DESCRIPTION OF THE INVENTION

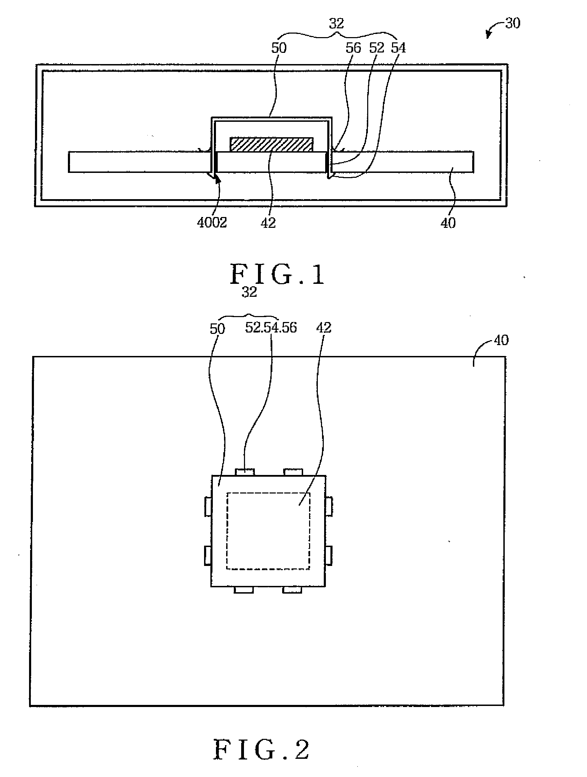

With reference to Fig. 1 and Fig. 2, which illustrate a schematic side sectional view of an electromagnetic-shielding device 32 combined with a PCB 40 of the present invention and a schematic top view of the electromagnetic-shielding device 32 combined with the PCB 40 of the present invention. The electromagnetic-shielding device 32 provided by the present invention is disposed in an electronic device for shielding electromagnetic interference. A PCB 40 and an electric component 42 thereon are disposed in the electronic device 30.

The electromagnetic-shielding device 32 includes a shielding mask 50, at least one positioning structure 52, and at least one interfering structure 54. As shown in Fig. 2, there are eight positioning structures 52 and eight interfering structure 54. The shielding mask 50 is disposed on the PCB 40 and covered the electric component 42.

One end of the positioning structure 52 is firmly connected to the shielding mask 50 and elongated downward from the shielding mask 50, another end is elongated downward into at least one hole 4002 of the PCB 40. As shown in Fig. 1, which is a preferred embodiment, one end of the positioning structure 52 is firmly connected to the edge of the shielding mask 50 and downwardly elongated from the edge into the hole 4002 of the PCB 40.

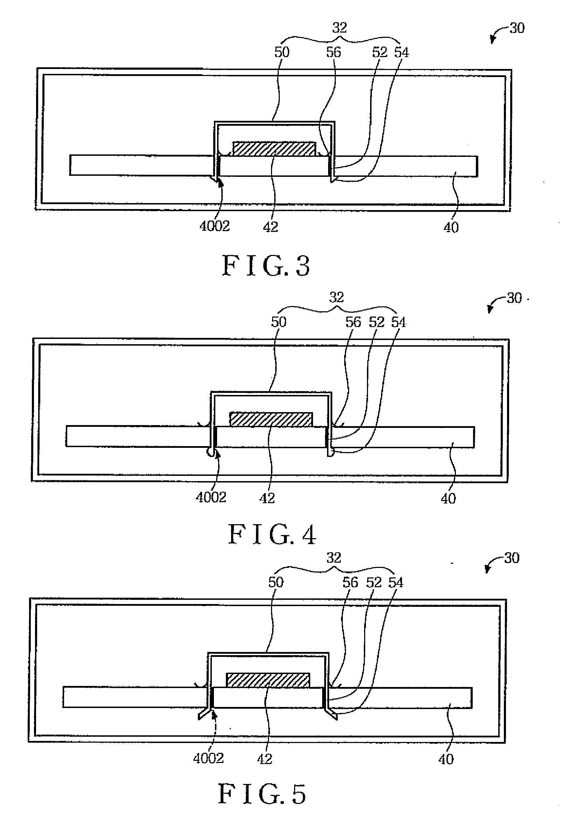

In an exemplary embodiment, a traversely elongated positioning member 56 is formed on the central portion of the positioning structure 52, which positioning member is against the upper surface of the PCB 40. When the positioning structure 52 is elongated to the edge of the shielding mask 50, the positioning member 56 is arranged to be positioned so that it is traversely elongated to the inner side or to the outer side of the shielding mask 50. Either the positioning member 56 elongated to the inner side or the outer side is urging the surface of the PCB 40 in order to prevent that the shielding mask 50 be freely moveable downward to touch the electric component 42. As shown in Fig. 1 the positioning member 56 is traversely elongated to the outer side of the shielding mask 50, and in Fig. 3 positioning member 56 is traversely elongated to the inner side of the shielding mask 50.

Referring now to Fig. 1, the interfering structure 54 is disposed at the one end of the positioning structure 52 and interfering in the PCB 40 in order to stably dispose the shielding mask 50 on the PCB 40.

The interfering structure 54 is a reverse hook structure, a protruding structure, or a bending structure so as to interfere in the PCB 40 and ensure that the positioning structure 52 is stably disposed on the PCB 40 and thereby ensure that the shielding mask 50 is firmly disposed on the PCB 40.

As the reverse hook of the interfering structure 54 shown in Fig. 1 and Fig. 3, the interfering structure 54 is arranged to traversely protrude from the other end of the positioning structure. Fig. 4illustrates a schematic view of another protruding structure of the interfering structure 54 of the present invention. That is, the interfering structure 54 can be, for example, the reverse hook structure or the protruding structure. The protruding structure traversely protrudes from the other end of the positioning structure 52, and the protruded surface of the protruding structure forms two curves on both upper and lower surfaces so as to facilitate installation and dismantling.

Fig. 5 illustrates a schematic view of a bending structure of the interfering structure 54 of the present invention. The interfering structure 54 can be a bending structure 54 as well, and is arranged to traversely protrude from the other end of the positioning structure 52. The bending structure is simple and saves the cost of manufacturing.

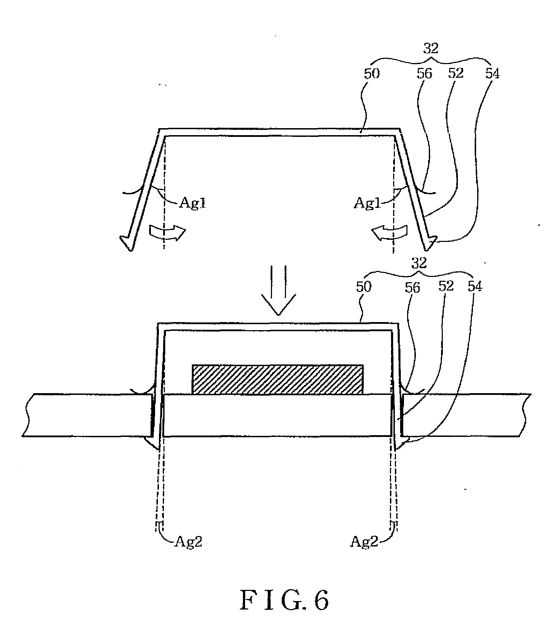

Fig. 6 illustrates a schematic view of installing the positioning structure 52 of the present invention. As aforesaid electromagnetic-shielding device 32, wherein the positioning structure 52 is preferably a flexible structure, and the positioning structure 52 is traversely deformed and recovered by an elastic force in order to interfere in the PCB 40.

Further, before firmly disposing the shielding mask 50 on the PCB 40, the positioning structure 52 is firstly dilated an angle, defined by the positioning structure and the vertical direction Ag1, and moved downward from the shielding mask 50. After that, the angle Ag1 is changed to a combining angle Ag2. By way of such angle conversion, the elastic force makes the interfering structure 54 tightly interfere in (fasten to) the PCB 40.

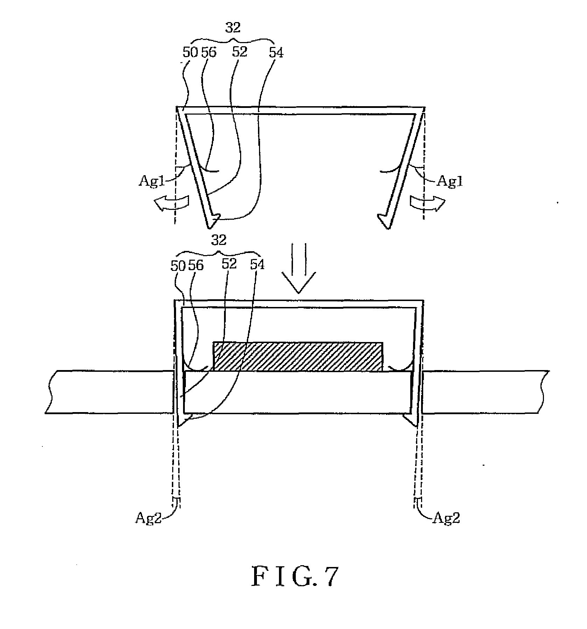

Fig. 7 illustrates another schematic view of installing the positioning structure 52 of the present invention. As aforesaid electromagnetic-shielding device 32, the positioning structure 52 is a flexible structure and generates a traverse deformation to tightly fasten the PCB 40.

Further, before firmly disposing the shielding mask 50 on the PCB 40, the positioning structure 52 is firstly contracted an angle, defined by the positioning structure and the vertical direction Ag1, and moved downward from the shielding mask 50. After that, the angle Ag1 is changed to a combining angle Ag2. By way of such angle conversion, the elastic force makes the interfering structure 54 tightly interfere in (fasten to) the PCB 40.

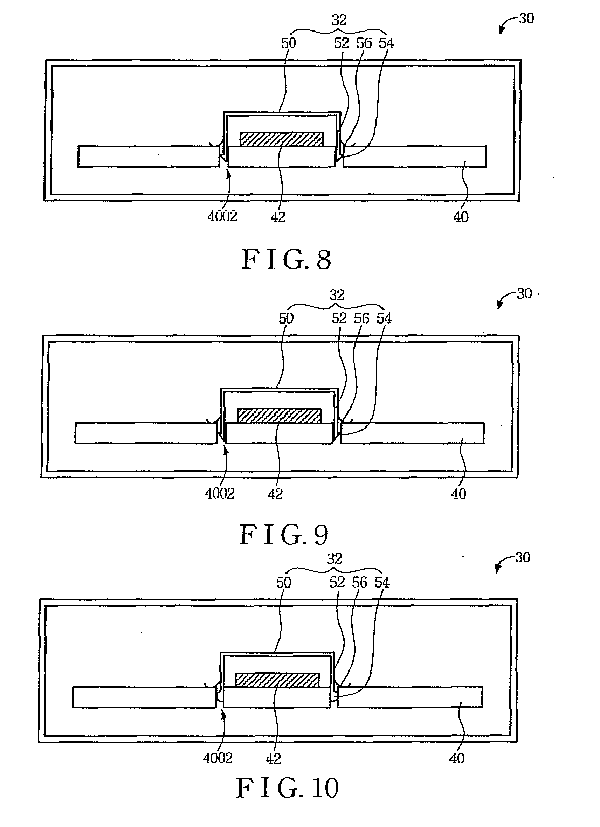

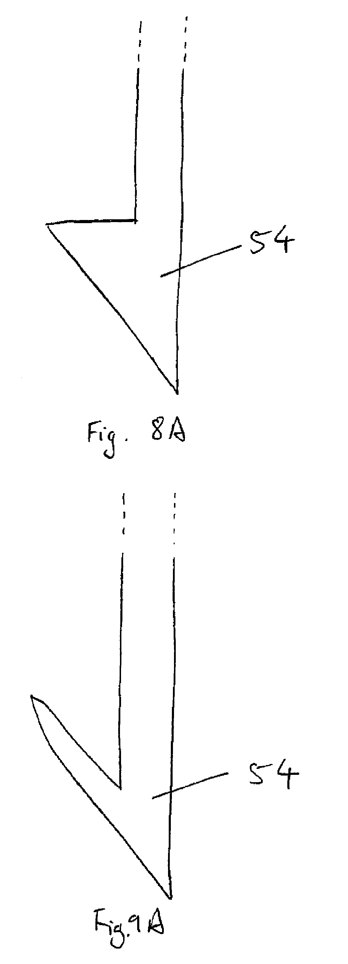

The ways of interfering as mentioned above is to let the interfering structure 54 of the positioning structure 52 be elongated downward into a hole 4002 of the PCB 40 so as to interfere the surface of the bottom of the PCB 40, or elongated downward and through the hole 4002 of the PCB 40 so as to interfere the surface of the hole 4002 of the PCB 40. Fig. 1, Fig. 3, Fig. 4, and Fig. 5 show the preferred embodiments of the interfering structure 54 interfering the surface of the bottom of the PCB 40. Fig. 8 illustrates a schematic view of another preferred embodiment of the interfering structure 54 interfering the surface of the hole 4002 of the present invention.

As shown in Fig. 8, the top end of the positioning structure 52 is still firmly connected to the edge of the shielding mask 50 and elongated downward from the shielding mask 50. The another end (lower end) of the positioning structure 52 is elongated downward into the hole 4002 of the PCB 40, but not in the same way as depicted in Fig. 1. which is that the other end (lower end) is penetrated into the hole 4002, and thus the another end interferes the surface of the hole 4002.

Fig. 9 illustrates a schematic view of a second preferred embodiment of the interfering structure 54 interfering the surface of the hole 4002 of the present invention. As shown in Fig. 8, the interfering structure 54 having a shape of reverse hook is inserted into the hole 4002, and the interfering structure 54 interferes the surface of the hole 4002 so as to achieve more stable effect for positioning, as shown in Fig. 9. Fig. 8A and Fig. 9A make clear the difference between the two interfering structures 54 of Fig 8 and Fig. 9. Fig. 8A shows the interfering structure of Fig. 8 and further Fig 9A shows the interfering structure of Fig. 9 and clearly show that it has the form of a reverse hook.

Fig. 10 illustrates a schematic view of a third preferred embodiment of the interfering structure 54 interfering the surface of the hole 4002 of the present invention. The third preferred embodiment can also adopt the protruding structure of the interfering structure 54, as shown in Fig. 4. That is, the protruding structure generates a little deformation to embed into the hole 4002 so as to achieve more stable effect as well.

The shielding mask 50 is a metal member for better electromagnetic-shielding effect. For saving manufacturing cost, the whole electromagnetic-shielding device 32 can be made of metal material. Therefore, the electromagnetic-shielding device 32 can be made by way of integration.

As a conclusion, the present invention adopts the positioning structure 52, the interfering structure 54, and the hole 4002 of the PCB 40 to assemble each other so as to produce the electromagnetic-shielding device 32 of the electronic device 30. The range of applied materials is wider, and the electromagnetic-shielding device 32 is easily dismantled and assembled so as to save manufacturing and maintenance cost.

Although this invention has been disclosed and illustrated with reference to particular embodiments, the principles involved are susceptible for use in numerous other embodiments that will be apparent to persons skilled in the art. This invention is, therefore, to be limited only as indicated by the scope of the appended claims.

## Claims

1. An electromagnetic-shielding device disposed in an electronic device for shielding electromagnetic interference, a PCB and an electric component thereon being disposed in the electronic device, and comprising:
a shielding mask disposed on the PCB and covered the electric component;
at least one positioning structure, which one end is firmly connected to the shielding mask and elongated downward from the shielding mask, another end being elongated downward into at least one hole of the PCB; and
at least one interfering structure disposed at the one end of the positioning structure and interfering the PCB in order to stably dispose the shielding mask on the PCB.

2. The electromagnetic-shielding device according to claim 1, wherein the one end of the positioning structure is firmly connected to an edge of the shielding mask.

3. The electromagnetic-shielding device according to claim 1, wherein a traversely elongated positioning member is formed on a central portion of the positioning structure, which positioning member is against an upper surface of the PCB.

4. The electromagnetic-shielding device according to claim 1, wherein the interfering structure is a reverse hook structure, which traversely protrudes from the another end of the positioning structure.

5. The electromagnetic-shielding device according to claim 1, wherein the interfering structure is a protruding structure, which is traversely protrudes from the another end of the positioning structure.

6. The electromagnetic-shielding device according to claim 1, wherein the interfering structure is a bending structure, which is traversely protrudes from the another end of the positioning structure.

7. The electromagnetic-shielding device according to claim 1, wherein the positioning structure is a flexible structure, and the positioning structure is traversely deformed and recovered by an elastic force in order to interfere the PCB.

8. The electromagnetic-shielding device according to claim 1, wherein the shielding mask is a metal member.

9. The electromagnetic-shielding device according to claim 1 is integrated as a whole member.

10. The electromagnetic-shielding device according to claim 1, wherein the another end of the positioning structure is elongated downward and through the hole of the PCB so as to interfere a surface of a bottom of the PCB by the interfering structure.

11. The electromagnetic-shielding device according to claim 1, wherein the another end of the positioning structure is elongated downward and through the hole of the PCB so as to interfere a surface of the hole of the PCB by the interfering structure.
